# EUROPEAN PATENT APPLICATION

(11) **EP 1 058 303 A1**
(43) Date of publication of application: **06.12.2000**
(21) Application number: 99830334.1
(22) Date of filing: 31.05.1999
(51) Int. Cl.: H01L 21/336, H01L 29/10, H01L 29/78, H01L 21/266

(54) **Fabrication of VDMOS structure with reduced parasitic effects**

(71) Applicant: STMicroelectronics S.r.l., 20041 Agrate Brianza (Milano) (IT)
(72) Inventor: Frisina, Ferruccio, 95030 Sant'Agata Li Battiati (IT)
(74) Representative: Pellegri, Alberto

(57) **Abstract**

A process for fabricating a VDMOS structure comprising the steps of forming a body region of a first conductivity type (p-) by implanting and diffusing a dopant (B) through a first aperture defined by the edges of a patterned gate conductor layer (4) on a dielectric gate layer (3) formed on the surface of an epitaxial layer (n). forming region (p+) with a higher dopant concentration within said body region (p-) by implanting dopant at a high kinetic energy down to a certain depth from the surface of the epitaxial layer, implanting and diffusing source regions of a second conductivity type (n+) in said body region (p-) projectively above said region of higher doping level (p+), comprises the following steps:
- forming a resist mask (Ms) defining apertures for implanting said source regions prior to the formation of said region (p+) of higher doping level:
- implanting through said resist mask (Ms), said dopant of a second conductivity type (n+) in a superficial zone of said body region (p-). and a dopant of said first conductivity type at a kinetic energy sufficient to implant the dopant (p+) at a depth below said superficial zone implanted with a dopant (n-) of the second conductivity type;
- annealing at a temperature and for a time sufficient to form (n+) source/ (p-) body junctions above body regions (p+) of a relatively high dopant concentration (p+).

An effective reduction of the gain of the parasite transistor is achieved without the need of a dedicated masking step.

## Description

The present invention relates to field effect transistors. More in particular the invention relates to a vertical, double diffused VDMOS device.

A VDMOS integrated structure includes source, body and drain regions of alternate type of conductivity defined in a semiconductor electrically in series with each other. The body region is a diffused region that extends in depth into the semiconductor while the source and drain regions are disposed so as to define a certain length and width of a channel region in the body region near the surface of the semiconductor. An insulated gate electrode is formed on the surface of the semiconductor, geometrically above the channel region.

In operation, by applying an appropriate voltage on the gate electrode the type of conductivity of the diffused body region in the portion defined as the channel region between the source and drain regions and directly underneath the gate electrode, is inverted forming a superficial channel in a depleted channel region.

The inversion channel allows a current flow between the source region formed inside the body region and the drain region of the device, which commonly surrounds the body region and which may be contacted on the bottom face of the semiconductor wafer.

A typical VDMOS structure is described in the US Patent 4,145,700.

The structure constituted by the distinct regions of source, body and drain of a VDMOS device in the semiconductor substrate determines the existence of either a NPN or PNP parasite junction bipolar transistor, depending on the respective types of conductivity of the regions of the VDMOS transistor structure.

The inevitable presence of this parasite bipolar transistor structure is detrimental for important electrical characteristics of the VDMOS structure and its effect must be contrasted. Thence, many ways have been proposed in order to depress as much as possible the gain of such a parasite bipolar transistor.

The known techniques for reducing as much as possible the gain of the parasite bipolar transistor are substantially of two types.

A first approach consists in short-circuiting the base and the emitter of the parasite transistor with the metal that contacts and connects the source region of the VDMOS structure.

A second and most commonly followed approach consists in increasing as much as possible the doping level of the base region of the parasite transistor represented by the body region of the VDMOS structure.

Although the latter approach is of easy implementation in a normal manufacturing process of a VDMOS structure, it contrasts with the objective of maintaining a voltage threshold of the VDMOS comprised between 1 and 5 volts which imposes to keep the dopant concentration in the body region of about 10¹⁶ and 10¹⁷ atoms/cm³, which is definitely insufficient to effectively lower the gain of the parasite bipolar transistor.

These contrasting requisites and incompatibilities are generally overcome by forming a body region which is not homogeneous but in the form of two layers or diffused regions formed independently the one from the other. A first zone of the body region establishes the concentration of dopant in the superficial channel region and thereby the turn-on threshold voltage, whereas the other zone of the body region has a relatively higher dopant concentration in order to provide for a base region of the parasite transistor with a high dopant concentration so as to remarkably reduce its gain.

These two zones of the body region with a different dopant concentration are made by two distinct dopant implants. For instance, with a dose of about 10¹³ atoms/cm² for the implantation that determines the turn on threshold voltage of the device and with a increased dose of implant of about 10¹⁵ atoms/cm² or even greater in order to increase to dopant concentration in the zone that constitutes the base region of the parasite transistor.

Commonly, this differentiation of the dopant level of the body region is made possible by either using two distinct masks or by other additional processing steps, in a word by increasing the complexity of the fabrication process.

### BACKGROUND OF THE INVENTION.

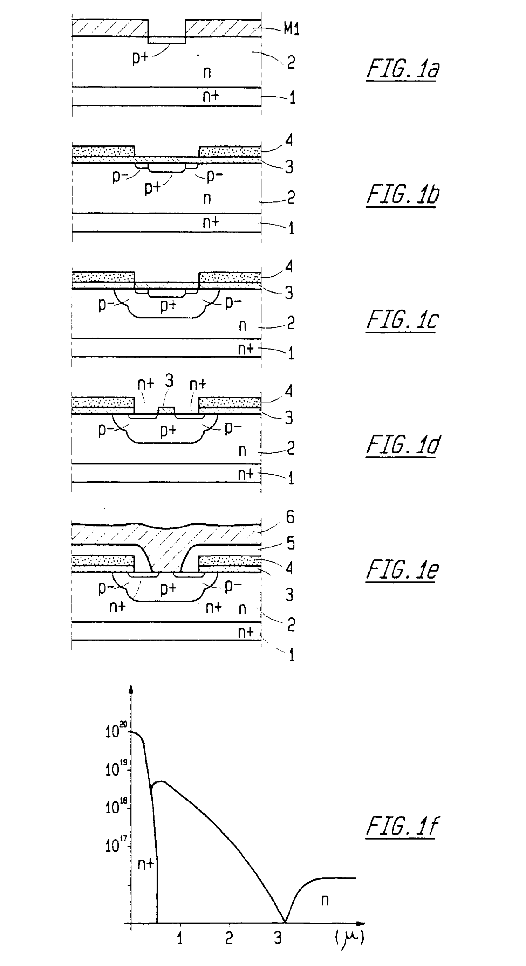

The figures 1a to 1e schematically illustrate the basic steps of a process of the prior art for realizing a so-called deep body region having an increased dopant concentration in order to decrease the gain of the parasite structure.

According to this known process, through a purposely reduced aperture of a mask M1, typically constituted by a patterned layer of silicon oxide with a thickness generally comprised between 1 to 2 µm, a first implantation is carried out. In the considered example, the implanted dopant B is boron. The implant is generally made at 60 to 100KeV, with a dose generally comprised between 5∗10¹⁴ and 5∗10¹⁵ atoms/cm².

This heavy implantation, carried out through the relatively reduced mask aperture prevents that a subsequent lateral diffusion of the implanted dopant may reach the channel region, which would increase the threshold voltage of the device.

A second body implantation is performed after having grown a gate oxide layer 3 on the N-type epitaxial semiconductor grown over the n+ semiconductor substrate. This reduced dose boron implantation, generally of 10¹³ to 10¹⁴ atoms/cm², at 80 to 100KeV, forms the superficial p- body region in which the channel region of the structure is established, thus ensuring the desired turn-on threshold voltage of the device. This second shallower body implantation takes place through an aperture defined in a polysilicon layer 4 which will constitute the gate electrode of the device.

As shown in figure 1c, the dopant implanted in the two distinct steps is diffused in the semiconductor, producing the characteristic profile of the body diffusion.

Thereafter, the layer of gate oxide is removed by masking and etching steps and the n+ source implant is carried out as depicted in figure 1d.

Figure 1e shows the details of the structure after the deposition of an insulating dielectric layer 5, the opening of it aperture in the source contact zone and the deposition of a metal layer 6.

Figure 1f shows the doping characteristic across a section of the epitaxial layer 2.

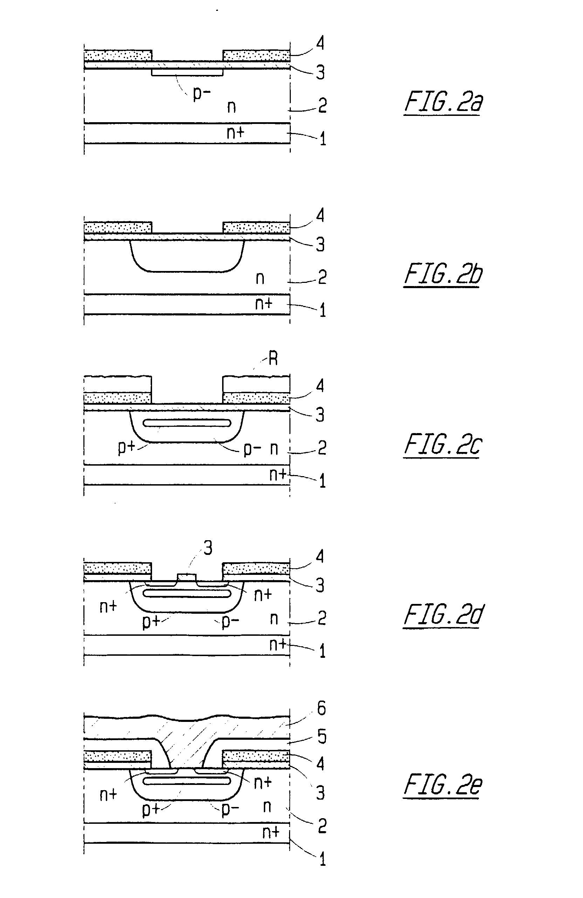

The set of figures 2a-2g schematically shows another known process that does not contemplate the realization of the so-called deep body. This method consists in realizing a buried body region (SHALLOW BODY) having a high dopant concentration as described in the US Patent 4,587,713.

According to this alternative technique, through the aperture defined in the polysilicon layer 4, a first boron implantation of a moderate dose is carried out to ensure the desired turn-on threshold voltage of the device, as shown in Figure 2a. This is followed by the dopant diffusion as depicted in Figure 2b.

Thereafter, through a second resist mask R, a second boron implantation is effected at relatively high kinetic energies of about 150 to 500 keV and in a dose sufficient to form a p+ region with a relatively high doping level at a certain depth and within the p- body diffusion already formed. The concentration peak of this p+ region, often referred to as "shallow body" should be located beneath the future source zone and this is realized by using an appropriate implantation energy. This step is schematically illustrated in Figure 2c.

The fabrication process continues, similarly to the preceding case, with the masking and etching of the gate oxide layer 3 in the source zone and with the n+ source implant directly above the previously formed heavily doped p+ region (shallow body), as shown in figure 2d.

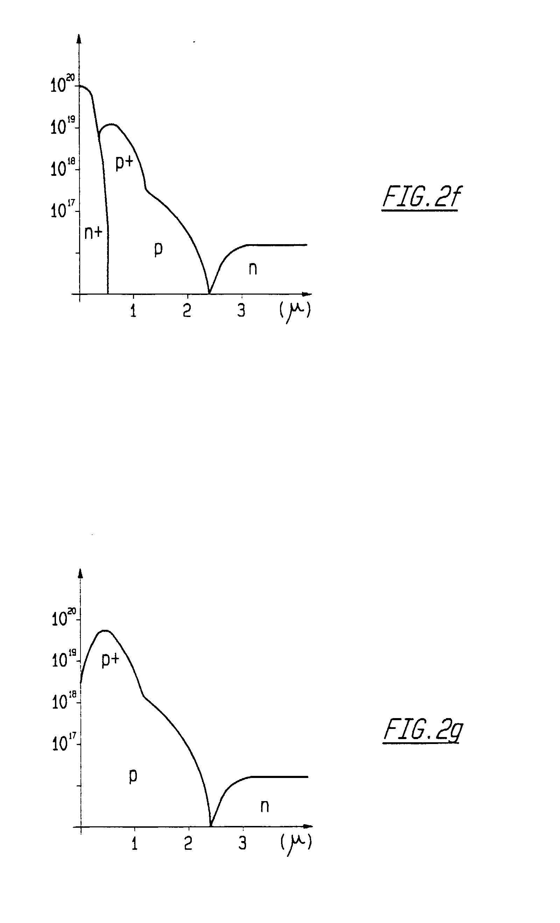

Figure 2e is a schematic cross section of the complete functional structure, and figures 2f and 2g show the doping characteristics along a section crossing the source region and along a section non crossing the source region.

A second masking stage becomes necessary because if the high energy implant should be subjected to the annealing treatment of the body region, there would be a lateral diffusion of dopant and an expansion of the highly doped region reaching the region beneath the electrode 4, that is the channel region, which would undesirably alter the threshold voltage.

In order to eliminate the need for two distinct masking steps the process described in the US Patent 4,774,198 of the same applicant, contemplates the realization of spacers on the patterned edges of the polysilicon and the implantation of the highly doped buried region p+ through the so restricted aperture by silicon oxide spacers, while reducing the kinetic energy so that the implant is sufficiently shielded by the polysilicon layer (the shielding provided by a relatively thick masking resist layer does not exist in this case).

Thereafter, the fabrication process, includes the elimination of the purposely formed spacers by a selective etching in order to open the source areas and the successive n+ implant, according to a normal fabrication sequence of operations.

Despite the advantage of eliminating the need for a second masking operation, the limitation of the kinetic energy of implant that may be used without negatively affecting the electrical characteristics due to the passage of dopant through the masking gate electrode layer is an important drawback that is further accentuated by the scaling down of integrated devices.

### SUMMARY OF THE INVENTION

Vis-a-vis these limitations and drawbacks, a fabrication method has now been found that eliminates the need for a second masking operation while permitting to use kinetic energy of implant without particular constraints due to the relatively limited shielding capacity of an already patterned polysilicon gate layer. The implant is indeed carried out through a resist mask having an adequate shielding capacity. Furthermore, the improved method of the invention also eliminate the need for additional operations as those required to form spacers of silicon oxide.

In practice, the novel method of the invention produces a substantial reduction of the complexity of the known processes, as well as a substantial elimination of the critical limits and of occasionally insufficient shielding during the high energy implant of dopant to form a highly doped buried shallow body region. The new method offers a wide range of choices of implanting energies, and allows for a more precise positioning of the highly doped buried body region, inside a light doped body region previously formed with an appropriate dopant level such to ensure the desired threshold voltage of the device.

Essentially, the fabrication method of the invention consists in forming, after having formed the properly doped diffused body region, a resist mask that defines the implantation apertures of the source region, prior to the formation of the highly doped buried region inside the body region previously formed by implantation and diffusion of the dopant.

Through this resist mask a dopant of the same conductivity type of the pre-formed body region is implanted at a sufficiently high kinetic energy, such that the implantation may extend down to a certain depth from the surface of the semiconductor substrate.

Another dopant of conductivity type opposite to the conductivity of the dopant used to realize the body regions is implanted through the same mask. The implantation of this other dopant is performed at a lower kinetic energy than the one used to implant the dopant of the highly doped buried body region, such to constitute source regions, geometrically above the highly doped buried body regions, that is in a superficial zone of the body region.

In view of the fact that the diffusion of the dopant implanted in the source region typically requires an annealing process at approximately 900-1000°C for 10-20 minutes, or an RTA, at 1100-1150°C, for 20-40 seconds, the doping profile of the superficial body zone remains practically unaltered and the threshold voltage is unmodified.

The resist mask provides for a perfect shielding of those areas sensitive to high energy implantations, through a masking step is eliminated from the flow-sheet of a standard fabrication process. Neither are necessary additional steps to form dielectric spacers along the defined aperture of the source area through the polysilicon gate layer, according to the alternative known process mentioned above.

### BRIEF DESCRIPTION OF THE DRAWINGS

The various aspect and advantages of the invention will be even clearer through the following description of an embodiment and by referring to the attached drawings, wherein:
**Figures 1a-2g** illustrate, as already described, the known processes;
**Figures 3a-3g** illustrate the process of the invention.

### DESCRIPTION OF AN EMBODIMENT OF THE INVENTION

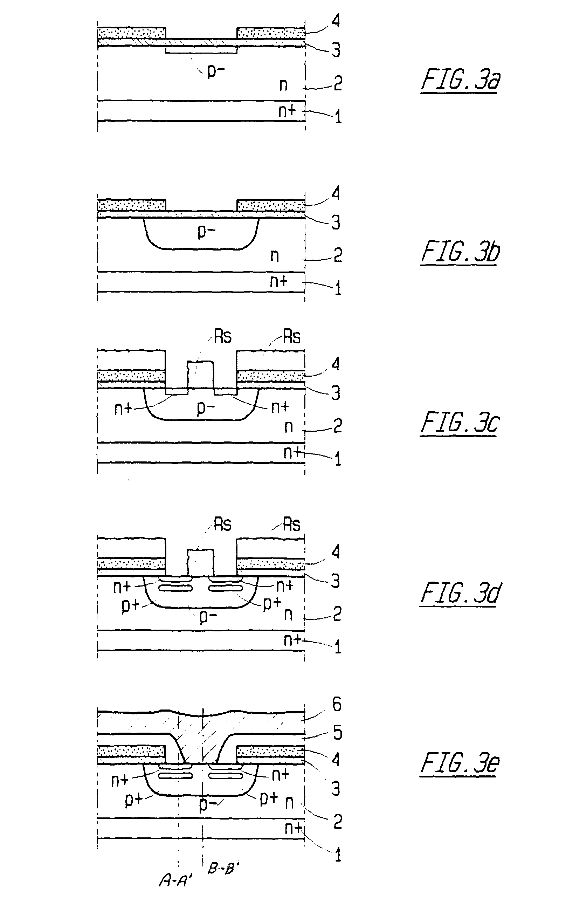

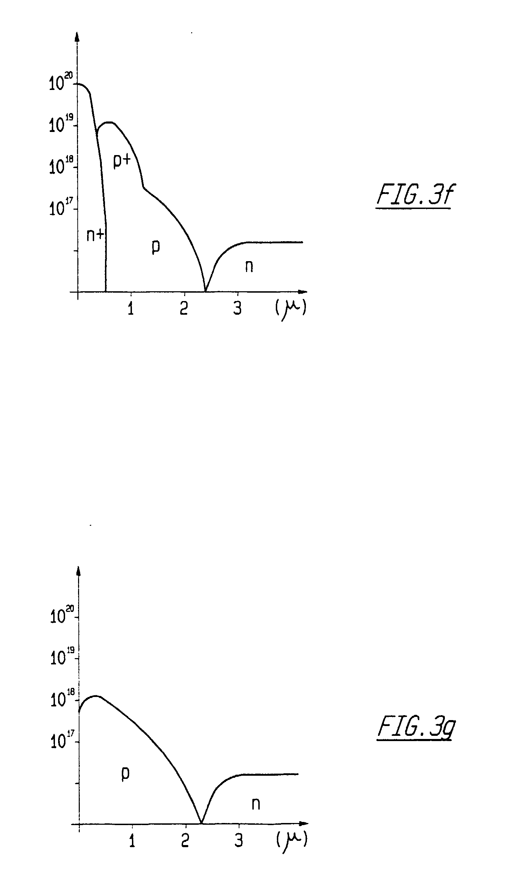

The ensuing description of an embodiment of the process of the invention refers to the set of figures 3a-3g, wherein the same parts are identified with the same numbers as used in the set of figures illustrating the known processes.

In the reported sample embodiment, a silicon wafer whit bulk resistivity of about 5-10 mΩcm and an n+ type conductivity is employed.

The n epitaxial layer may have a thickness of about 5µm when fabricating devices that must exhibit a breakdown voltage of around 100V, or of about 30µm when fabricating devices that must exhibit a breakdown voltage of more than 500V. The bulk resistivity of the n epitaxial layer may be respectively of 2Ωcm or of about 20Ωcm.

Salient steps of the process of the invention for fabricating an n-channel VDMOS structure referred to as a p+ shallow structure, are as in a standard process, a first p- body implant, carried out through apertures in the polysilicon gate layer 4, already defined over the gate oxide layer 3. The gate oxide layer 3 may have a thickness ranging between 20 and 180 nm. The polysilicon gate layer 4 may have a thickness of about 300 and 700nm.

In the example considered the body implant of boron is done with doses ranging from 10¹³ to 10¹⁴ atoms/cm², and with a kinetic energy of implant that may vary between 80 and 100 KeV.

After implantation boron is diffused by annealing at a temperature of 900 to 1150°C for a time of 1 to 4 hours, producing a classical profile of the diffused region as depicted in Figure 3b.

According to a fundamental aspect of the process of the invention, a resist Rs mask for the source implant as contemplated in a normal process is formed after the annealing, and the n+ source implant and the p+ implant are carried out through the same resist mask Rs.

Generally, the source implant, depicted in figure 3c, is done with phosphorous or arsenic, in doses that may range between 10¹⁵ and 6∗10¹⁵ atoms/cm², at a kinetic energy of 40 to 60KeV, in order to implant a superficial region of the silicon epitaxial layers for a depth of about 0.2-0.5µm.

Boron for realizing the p+ shallow structure is implanted through the same Rs resist mask, at a kinetic energy of 150 to 500KeV, in doses of about 10¹⁴ to 10¹⁵ atoms/cm².

Therefore, boron is implanted directly beneath the n+ source implant.

Upon completing the two implants, n+ source and p+ shallow, respectively, a brief annealing treatment of source dopant diffusion is effected. Notably, this source annealing treatment has an extremely low thermal budget. The treatment may be carried out at 950°C, for about 15 minutes. Alternatively, an RTA treatment may be implemented at 1100°C for about 30 seconds. During this annealing treatment, the n+ source/p- body junctions are established.

Because of these limited conditions of thermal budget, the doping profile of the superficial zone of the body region, that is where the source junctions are formed, remains practically unaltered without the occurrence of any substantial variation of the threshold voltage.

After removing the resist mask Rs and etching the oxide layer over the source areas, an insulating dielectric layer 5 is deposited according to the normal sequence of steps of a standard process, followed by the opening of the source contacts and the deposition of the metal layer 6.

Figures 3f and 3d are dopant concentration diagrams relative to the cross sections A-A' and B-B', identified in figure 3e.

The p+ shallow structure of the invention effectively reduces the gain of the parasite bipolar junction transistor of the VDMOS transistor structure, while eliminating a masking step with evident advantages. These results are achieved averting any degradation of the electrical properties of the gate dielectric, because the resist mask ensures an effective shielding of sensitive areas during the high energy implantation.

## Claims

1. A process for fabricating a VDMOS structure comprising the steps of forming a body region of a first conductivity type (p-) by implanting and diffusing a dopant (B) through a first aperture defined by the edges of a patterned gate conductor layer (4) on a dielectric gate layer (3) formed on the surface of an epitaxial layer (n), forming region (p+) with a higher dopant concentration within said body region (p-) by implanting dopant at a high kinetic energy down to a certain depth from the surface of the epitaxial layer, implanting and diffusing source regions of a second conductivity type (n+) in said body region (p-) projectively above said region of higher doping level (p+),
characterized in that it comprises
forming a resist mask (Ms) defining apertures for implanting said source regions prior to the formation of said region (p+) of higher doping level;
implanting through said resist mask (Ms), said dopant of a second conductivity type (n+) in a superficial zone of said body region (p-), and a dopant of said first conductivity type at a kinetic energy sufficient to implant the dopant (p+) at a depth below said superficial zone implanted with a dopant (n-) of the second conductivity type;
annealing at a temperature and for a time sufficient to form (n+) source/ (p-) body junctions above body regions (p+) of a relatively high dopant concentration (p+).

2. The process according to claim 1, characterized in that said VDMOS structure has a n-channel conductivity, said epitaxial layer of said second conductivity type has a bulk resistivity comprised between 2Ωcm and 20Ωcm, said first implant to form said body region (p-) being of boron accelerated at a kinetic energy comprised between 60 and 100 keV, in doses comprised between 10¹³ and 10¹⁴ atoms/cm², said implant (n+) of the dopant of a second conductivity type being of phosphorous at a kinetic energy comprised between 40 and 60 keV in doses comprised between 10¹⁴ and 6∗10¹⁵ atoms/cm² and said implant at a high energy being of boron, at a kinetic energy comprised between 150 and 500 keV, in doses comprised between 10¹⁴ and 10¹⁵ atoms/cm².

3. The method according to claim 2, characterized in that said annealing treatment is carried out at a temperature comprised between 900 and 1000°C for a time span comprised between 10 and 20 minutes.

4. The method of claim 2, characterized in that said annealing is effected at a temperature of 1100°C to 1200°C for a time of 20 to 40 seconds.
